# EUROPEAN PATENT APPLICATION

(11) **EP 4 053 304 A1**
(43) Date of publication of application: **07.09.2022**
(21) Application number: 21159980.8
(22) Date of filing: 01.03.2021
(51) Int. Cl.: C23C 14/50, C23C 14/54, C23C 14/56, B08B 7/00, C03C 17/00

(54) **COATER CONDITIONING MODE**

(71) Applicant: Bühler Alzenau GmbH, 63755 Alzenau (DE)
(72) Inventor: LIU, Simon, 63500 Seligenstadt (DE); FRANK, Marcus, 60439 Frankfurt (DE)
(74) Representative: Vossius & Partner Patentanwälte Rechtsanwälte mbB

(57) **Abstract**

A method of conditioning a coater for removing water and/or moisture from a processing area of the coater is provided, the processing area comprising at least one pump compartment (10) and at least one sputtering compartment (11). The method comprises the steps of loading conditioning substrates (5) into the processing area, so that the processing area is substantially filled with the conditioning substrates (5) and conditioning the coater by starting a sputtering process in the processing area and/or by heating of at least the one pump compartment (10). During conditioning, the conditioning substrates (5) perform an oscillating movement in the processing area.

## Description

The present invention relates to coating devices, in particular large area coaters for coating glass substrates by a sputtering process. The invention particularly relates to conditioning a coater after a maintenance process.

Generally, after a maintenance process on a large area coater, the machine is closed and pumped down. After pumping, the coater needs to be "conditioned". "Conditioning" is in general a synonym for pumping the water out of the coater. The water is adsorbed at the entire surfaces inside the coater and to efficiently pump the water, it needs to be detached from the surfaces - a process which requires heat. Two different state of the art conditioning processes are known:
As soon as a pressure is reached which allows to start the cathodes, the sputtering processes are started throughout the coater. The provided process power between 10kW and 120kW per cathode is mainly converted to thermal energy and hence heats the coater, predominantly in the area of the process compartments, where the sputtering processes are active, while the pump compartments are not heated actively. While the heating is the desired effect to detach the water from the surfaces to pump it out, there are two disadvantageous effects: (1) The sputtering targets are consumed without producing coated glass, (2) the sputtered material is deposited in the empty compartments building up thick layers of coating material with intrinsic stress, which increases the risk of debris (product failures) later when the coater is in production mode.

To minimize the before mentioned risk of debris, the conditioning procedure can be modified: While sputtering, e.g. out of spec glass is run through the coater continuously. This way the sputtered material is not deposited in the empty compartments but on the low quality glass, which carries the sputtered material out of the coater. Back to atmosphere the coated glass can be reused for this process. To do so, it needs to be transported from coater exit back to coater entrance. In the end of the conditioning process the coated glass is scrapped. This way the risk of debris during production can be reduced. However, this risk mitigation comes again with a couple of disadvantages: (1) The glass running through the coater while all sputtering processes are active, is heated significantly and helps, to also condition the pumping compartments, where no heating process is available. When leaving the coater, the glass has reached temperatures of about 60°C -70°C and hence extracts a significant amount of energy from the vacuum, where it is actually needed for conditioning. Back to atmosphere the glass just cools down while being transported back to coater entrance, where it is running through a washing machine and enters the coater again to be re-heated and to protect the compartment surfaces from being sputtered. (2) Running the glass in circles through the coater and from exit back to entrance multiple times, a significant layer stack is built up on the glass, which results into significant intrinsic stress and loss of adhesion. As a result, part of this coated material is removed during the harsh washing process prior to coater entrance, which is actually adjusted to wash uncoated glass. These coating particles removed mechanically by the brushes are contaminating the washing machine, which therefore needs to be cleaned prior to start of production.

As described in US 2007/254096 A1, a chamber of a coater is purged with a conditioned purge gas prior to a coating operation, wherein the moisture content of the purge gas is set to a predetermined moisture level, in particular to a relative moisture content of at most 30%. The chamber may be at least partially heated before and/or during the cleaning operation, to a temperature between 20° C and 60° C

According to WO 2006/127472 A1, for rapidly and inexpensively drying a (deposition) chamber of a coater, the chamber is flushed with dry air to remove contaminating moisture in the chamber prior to use.

It is therefore an object of the present invention to provide an improved conditioning method and coater device that in particular overcome the above problems.

The present invention is defined by independent claims 1 and 14; the dependent claims define embodiments of the present invention.

The present invention provides a method of conditioning a coater for removing water and/or moisture from a processing area of the coater. The processing area comprising at least one pump compartment and at least one sputtering compartment. According to the method of the present invention, conditioning substrates are loaded into the processing area of the coater, so that the complete processing area, and preferably a transfer chamber is substantially filled with the conditioning substrates. Then, a conditioning process of the coater is performed by starting a sputtering process in the processing area and/or by heating of at least the one pump compartment. During conditioning, the conditioning substrates perform an oscillating movement (back and forth) in the processing area.

The conditioning substrates may be metal substrates, in particular substrates with a specific heat capacity of at least 350 J/(kg^{∗}K), e.g. aluminium substrates. The conditioning substrates are preferably cleaned and reused after conditioning the coater.

Alternatively, the conditioning substrates are glass substrates of low quality. The glass conditioning substrates may be scrapped after conditioning the coater.

[[FMEB1]

The length of a conditioning substrate preferably substantially corresponds to the length of a sputtering compartment. The distance between two successive substrates in the coater the so called "gap" should be as small as possible to prevent the target material being sputtered in the coater. Typically, the gap is about 30mm -100mm. In relation to the length of the substrates used for conditioning, the gap, i. e. the distance between two successive substrates in the coater should be at most about 1/8^{th} to 1/12^{th} of the smallest substrate length.

The minimum amplitude of oscillation preferably substantially corresponds to the length of the sputtering compartment. The maximum amplitude of the oscillation is preferably the length of the transfer chamber and provided the coater is equipped with a buffer chamber the maximum amplitude can be enhanced to include the buffer chamber.

A heated conductance tunnel may be used for heating the at least one pump compartment.

The length of the conditioning substrates and/or the amplitude of oscillation is/are preferably selected such that only a single conditioning substrate is located in the sputtering compartment during oscillation.

The coating material may be recycled from the conditioning substrates after conditioning the coater.

During sputtering and/or heating, the detached water is preferably pumped.

During conditioning, it may be preferable to at least once temporarily stop the sputtering process and to at least partially vent the coater with any dry gas or atmosphere like Ar, O2, N2 or air. Subsequently the conditioning process may be resumed by pumping down the coater again and restart sputtering.

The conditioning process is preferably stopped when it is determined that the conditioning is completed by detecting that the remaining water partial pressure in the coater is below a predetermined threshold. Preferably, the water partial pressure in the coater is detected by using a residual gas analyser and/or a spectroscopic plasma emission monitoring system.

The present invention further provides a device for coating substrates, that in particular is configured to perform the above-described conditioning method. The device includes a processing area comprising at least one pump compartment and at least one sputtering compartment, and a driving means for moving the substrates through the processing area. The driving means is configured to move the substrates such that the substrates perform an oscillating movement in the processing area during conditioning by sputtering and/or heating. The device preferably further comprises a heating means, in particular a heated conductance tunnel, and/or means for determining the water partial pressure.

According to the present invention, to combine the advantages of the above described conditioning procedures of the prior art, and simultaneously eliminate their disadvantages, the following procedure is suggested according to an embodiment of the invention: The entire coater process area, potentially including entrance or exit transfer chambers, is filled with low quality or out of spec glass or any alternative substrate material, which provides a high heat capacity - preferably metal substrates like e.g. stainless steel or aluminum. The coater is closed at both ends, pumped down and sputtering processes and/or alternative or additional heating means are operated to heat the coater. The substrates now oscillate within the coater with an amplitude of the transfer chamber length or any other preferable amplitude.

This way the following advantages can be achieved: (1) The heat needed for conditioning is provided by the running sputtering processes. (2) The glass or the alternative substrate material protects the surfaces within the coater from being coated with sputtered material and hence reduces the above mentioned risk of debris. (3) With the oscillation, the pump compartments adjacent to the process compartments are heated by the hot substrate travelling from the high energy sputtering compartments to the "cold" pump compartments, which are not necessarily actively heated, and back.

Since the glass or the alternative substrate material is oscillating within the coater the following disadvantages can be eliminated: (1) The coater does not lose energy carried by the substrates as they are not leaving the vacuum anymore. The process heat is accumulated in the substrates and distributed in the colder areas of the coater (pump compartments), and as a consequence the sputtering energy needed for conditioning can be reduced without any negative impact on conditioning time. (2) There is no need to transport the substrate material from coater exit back to coater entrance. (3) The washing machine is not contaminated by coating particles removed from the multiply coated conditioning substrate during the washing procedure. Hence no particular cleaning procedure is needed anymore for the washing machine.

In case low quality glass is being used as a substrate during conditioning, it can be scrapped after the conditioning process. In case of any metal sheets being used, they can be cleaned (e.g. by sandblasting) and reused for the next conditioning process.

To avoid thermal stress in the substrate material, especially in case glass is being used as a conditioning substrate, it is advantageous to use alternative glass sizes, other than jumbo length, most preferably glass sizes similar to the compartment length that may be about 850 mm. Smaller dimensions may also be advantageous in case metal sheets are used, as smaller sizes can be handled easier during load and unload processes and for cleaning procedures as well (e.g. sand blasting).

To effectively recycle precious materials (e.g. silver) coated on the conditioning substrates, the substrates can be cut to special dimensions and arranged in a way that only silver is deposited on one substrate. After the conditioning process these particular substrates can be sorted out and the deposited precious material can be recycled from the substrate surface. All other substrates can be cleaned by sandblasting.

As the sputtering process is utilized to provide the energy needed for conditioning, the one and only remaining disadvantage is the waste of target material during the conditioning procedure, which is lost for production. This disadvantage can be eliminated by using a heated conductance tunnel in the pumping compartments or any other heating means or heatable components in the coater, which effectively transfer heat to the conditioning substrates. In case the thermal energy can be transferred to the substrate material by heated conductance tunnels or alternative components, the sputtering process can be reduced for conditioning purposes or even stopped to completely eliminate the waste of target material.

Ideally the optimized conditioning procedure according to the present invention can be complemented by an "alternating pumping and venting process": In a first sequence of the alternation the substrates are heated by the sputtering processes and/or by heated conductance tunnels, while the detached water is pumped. In the second sequence the sputtering process is stopped and the coater is partially vented with dry air or alternative gases as mentioned above and subsequently pumped again, while the substrates are continuously heated by the heatable conductance tunnels and/or by the sputtering process as soon as the pressure allows to start the cathodes.

Finally, the entire conditioning procedure with all described features and advantages can be completed with a suitable endpoint-detection for the remaining water partial pressure. Residual gas analyzers (RGAs) can be applied for this purpose in the most relevant compartments (e.g. cold pump compartments, Ag, or ZnO seed layer prior to the adjacent Ag compartment or any other favorable position in the coater). As an effective alternative spectroscopic plasma emission monitoring systems (PEMs) can also be applied monitoring relevant water emission wavelengths in essential process compartments as long as the plasma is turned on. Any other system can be used for endpoint-detection which senses the residual water partial pressure.

In the following, the present invention is described in more detail with reference to the Figures, wherein
Fig. 1 illustrates a coater performing a conditioning method according to the prior art,
Fig. 2 illustrates a coater performing a conditioning method according to an embodiment of the present invention,
Fig. 3 illustrates a coater including a precious material processing compartment performing a conditioning method according to an embodiment of the present invention, and
Fig. 4 illustrates a coater including a pump compartment equipped with a heatable conductance tunnel performing a conditioning method according to an embodiment of the present invention.

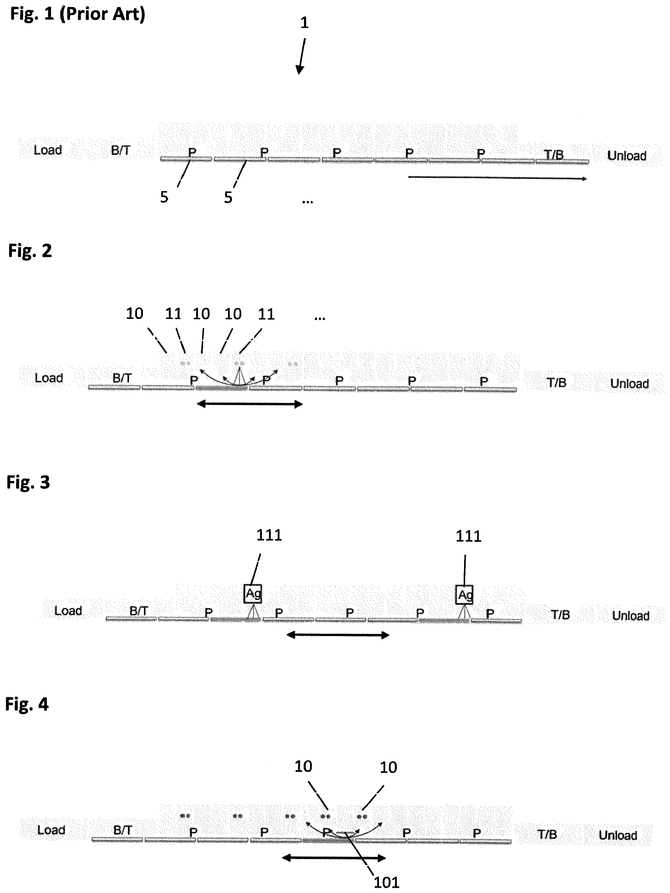

Fig. 1 illustrates a coater performing a conditioning process as known in the prior art described above. The coater includes a loading and an unloading compartment, buffer/transfer compartments B/T and a processing area 1 made up of a plurality of processing compartments P. The processing area 1 is subdivided into pump compartments and sputtering compartments which will be described below with reference to Fig. 2. A sputtering process is performed in the processing area for heating and thus conditioning the processing area while continuously moving an "endless train" of substrates 5 through the processing area, as indicated by the arrow under the coater illustrated in Fig. 1. According to the prior art, the substrates that are used when conditioning the coater correspond to the substrates that are usually used for producing coated substrates. These prior art processes suffer, however, from the problems described above, such as waste of energy and coated material.

According to the present invention, as illustrated in Fig. 2, the substrates perform an oscillating movement in the processing area 1 during conditioning, indicated by the arrow below the coater in Fig. 2. Preferably, the substrates oscillate within the coater with an amplitude that corresponds to the length of the transfer compartment (T or BT). Specific conditioning substrates may be used during conditioning, e. g. low quality glass substrates or metal substrates with a sufficient heat capacity. However, usual substrates that are normally used in the coater may equally be used during conditioning.

As shown in Fig. 2, the processing area 1 with the processing compartments P generally may be subdivided into pump compartments 10 and sputtering compartments 11. By operating the sputtering compartments 11, the (conditioning) substrates are heated that, in turn, heat the parts of the processing area that are not actively heated during sputtering, i. e. the pump compartments 10. This is indicated by the curved arrows inside the processing area, illustrating the flow of heat from the substrate area that is currently sputtered to the other compartments in the processing area. Heat may alternatively or additionally be introduced into the processing area during conditioning by using other heating means, such as a heatable conductance tunnel as described below with reference to Fig. 4.

During the sputtering process, detached water is pumped out of the processing area. In order to improve the conditioning efficiency, sputtering may temporarily be stopped during condition to at least partially vent the coater with dry air. Then, in order to continue the conditioning process, the coater may be pumped down again, and the sputtering process is continued.

In order to detect whether the coater is sufficiently conditioned, endpoint detection may be performed. This may be done by determining the remaining water partial pressure. As soon as the detected remaining water partial pressure falls below a predetermined threshold, conditioning may be stopped and the coater is ready for production. As described above, any appropriate system and method for measuring the remaining water partial pressure may be applied.

The amplitude of oscillation of the substrates during conditioning may, for example, substantially correspond to the length of the transfer chamber T or even include the buffer chamber B. In case of sputtering with a precious material, other amplitudes or substrate lengths may be advantageous, as will be explained with reference to Fig. 3 below. In order to ensure that substantially the entire coater is filled with substrates during conditioning, the distance between subsequent substrates should be kept as small as possible. For example, a distance being not more than about 30mm - 100mm or one eighth to one twelfth of the minimum substrate length may be appropriate.

To avoid thermal stress in the substrate material, especially in case glass is being used as a conditioning substrate, it is advantageous to use alternative glass sizes, other than the length usually used in a large area coater, most preferred glass sizes similar to the compartment length, which may be about 850 mm. Smaller dimensions may be advantageous in case metal sheets are used as conditioning substrates, as smaller sizes can be handled easier during load and unload processes and for cleaning procedures, e.g. sand blasting.

Fig. 3 shows, in addition to the illustration in Fig. 2, a compartment 111 where coating with a precious material is performed, such as silver (Ag) in the example shown in Fig. 3. In this case, in order to be able to effectively recycle the precious material, the conditioning substrates can be cut to special dimensions and arranged in a way that only precious material is coated on one substrate, due to the specific length of the substrate together with the oscillation amplitude that may be specifically adapted to the substrate length. After the conditioning process these specific conditioning substrates that have been coated with the precious material only, are sorted out and the deposited precious material can be recycled from the substrate surface. All other substrates can be cleaned, e.g. by sandblasting, and reused or just scrapped .

Since the sputtering process is utilized to provide the energy needed for conditioning, one remaining disadvantage may be the waste of target material during the conditioning procedure, which is lost for production. This disadvantage can be eliminated by using heating means or heatable components in the coater, which effectively transfer heat to the conditioning substrates e.g. heated conductance tunnels in the pumping compartments, as illustrated in Fig. 4. In case thermal energy can be transferred to the substrate material by heated conductance tunnels 101, the sputtering process can be reduced for conditioning purposes, or even stopped, to completely eliminate the waste of target material. Generally, it is possible to install additional heating means inside the coater at any suitable position, in order to be able to introduce thermal energy for conditioning, in addition or as an alternative to introducing heat by operating the sputtering process. A conductance tunnel is designed to provide a passage for the substrate from one processing compartment to another, while avoiding simultaneously an excessive process gas flow between the processing compartments. Therefore, the height of the conductance tunnel is minimized, resulting in a small distance between "tunnel roof" and substrate surface. For this reason, the conductance tunnel 101 is a preferred component, which, when heated, as shown in Fig.4 provides an effective heat transfer to the close by substrate. [FMEB2]

According to the present invention, oscillating glass or alternative substrates are arranged in a coater during conditioning to reduce risk of debris during production, and to keep the energy needed for conditioning in the processing area and simultaneously distribute it to the pumping compartments, without any heat loss to the atmosphere. To avoid excessive heat accumulated in the coater, the sputtering power may be reduced, which results in an energy efficient conditioning process. Further, moving substrates at atmosphere from coater exit to coater entrance can thus be avoided. Moreover, contamination of a washing machine, needed according to the prior art for washing the coated substrates before reintroducing them into the coater, with coating particles can be avoided.

Compared to low quality glass, higher heat capacity substrates may be preferred as conditioning substrates (e.g. stainless steel or aluminum) which can be cleaned by sandblasting after the conditioning process and reused.

Substrate sizes (length) should be optimized to avoid thermal stress created by heated and non-heated areas on one substrate - which can result into substrate breakage in case of glass. With metal sheets being used the risk of breakage is not existent, but smaller substrates will provide the advantage of easier handling (e.g. load, unload, cleaning)

The conditioning substrates are preferably arranged in a way that only one substrate is oscillating underneath a precious material sputtering process. This way, the deposited material can be recycled efficiently from those particular substrates after the conditioning process.

To provide the conditioning heat by running sputtering processes, a heatable conductance tunnel 101 or other heating means or heatable component in the coater can be applied additionally or as an alternative to heat the conditioning substrates. This way the waste of sputtering material can also be eliminated.

The conditioning process may be completed by an alternating pumping and venting procedure: In a first sequence of the alternation the substrates are heated by a heatable conductance tunnel, while the detached water is pumped. In the second sequence the coater is partially vented by dry air or alternative gases, which help to detach the water more efficiently and is subsequently pumped down again, while the substrates are continuously heated by the heatable conductance tunnel.

## Claims

1. Method of conditioning a coater for removing water and/or moisture from a processing area of the coater, the processing area (1) comprising at least one pump compartment (10) and at least one sputtering compartment (11), the method comprising the steps of:
- loading conditioning substrates (5) into the processing area (1), so that the processing area (1) is substantially filled with the conditioning substrates (5),
- conditioning the coater by starting a sputtering process in the processing area (1) and/or by heating of at least the one pump compartment (10), wherein, during conditioning, the conditioning substrates (5) perform an oscillating movement in the processing area.

2. Method according to claim 1, wherein the conditioning substrates (5) are metal substrates, in particular substrates with a specific heat capacity of at least 350 J/(kg^{∗}K), wherein the conditioning substrates (5) are preferably cleaned and reused after conditioning the coater.

3. Method according to claim 1 or 2, wherein the conditioning substrates (5) are glass substrates of low quality, wherein the conditioning substrates are preferably scrapped after conditioning the coater.

4. Method according to any one of the preceding claims, wherein the length of a conditioning substrate (5) substantially corresponds to the length of a sputtering compartment (11).

5. Method according to any one of the preceding claims, wherein the distance between two successive substrates (5) in the coater is at about 30 to 100 mm.

6. Method according to any one of the preceding claims, wherein the minimum amplitude of oscillation substantially corresponds to the length of the sputtering compartment (11).

7. Method according to any one of the preceding claims, wherein a heating means, preferably a heated conductance tunnel (101) is used for heating the at least one pump compartment.

8. Method according to any one of the preceding claims, wherein the length of the conditioning substrates (5) and/or the amplitude of oscillation is/are selected such that only a single conditioning substrate (5) is located in the sputtering compartment (11) during oscillation.

9. Method according to any one of the preceding claims, wherein the preferably precious coating material is recycled from the conditioning substrates after conditioning the coater.

10. Method according to any one of the preceding claims, wherein detached water is pumped during sputtering and/or heating.

11. Method according to any one of the preceding claims, wherein, during conditioning, sputtering is temporarily stopped, and the coater is at least partially vented with dry gas and subsequently pumped down again.

12. Method according to any one of the preceding claims, further comprising a step of stopping conditioning when determining that the conditioning is completed by detecting that the remaining water partial pressure in the coater is below a predetermined threshold.

13. Method according to claim 12, wherein the water partial pressure in the coater is detected by using a residual gas analyser and/or a spectroscopic plasma emission monitoring system.

14. Device for coating substrates, including:
a processing area (1) comprising at least one pump compartment (10) and at least one sputtering compartment (11), and
a driving means for moving the substrates (5) through the processing area (1), the driving means being configured to move the substrates such that the substrates (5) perform an oscillating movement in the processing area (1) during conditioning by sputtering and/or heating.

15. Device according to claim 14, further comprising a heated conductance tunnel (101) and/or means for determining the water partial pressure.
